# EUROPÄISCHE PATENTSCHRIFT

(11) **EP 2 987 179 B1**
(45) Veröffentlichungstag und Bekanntmachung des Hinweises auf die Patenterteilung: **25.01.2017**
(21) Anmeldenummer: 14716747.2
(22) Anmeldetag: 20.03.2014
(51) Int. Cl.: H01L 21/285, H01L 29/423, H01L 31/0224, H01L 31/108, H01L 23/528, H01L 29/778, H01L 29/20

(54) **HOCHFREQUENZLEITER MIT VERBESSERTER LEITFÄHIGKEIT**
HIGH-FREQUENCY CONDUCTOR WITH IMPROVED CONDUCTIVITY
CONDUCTEUR À HAUTE FRÉQUENCE PRÉSENTANT UNE CONDUCTIVITÉ AMÉLIORÉE

(30) Priorität: 18.04.2013 DE 102013006624
(43) Veröffentlichungstag der Anmeldung: 24.02.2016
(73) Patentinhaber: Forschungszentrum Jülich GmbH, 52425 Jülich (DE)
(72) Erfinder: MIKULICS, Martin, 52428 Jülich (DE); HARDTDEGEN, Hilde, 52064 Aachen (DE); GRÜTZMACHER, Detlev, 52382 Niederzier (DE)
(86) Internationale Anmeldenummer: PCT/DE2014/000149
(87) Internationale Veröffentlichungsnummer: WO 2014/169887

(56) Entgegenhaltungen:
- EP-A2- 1 978 472
- JP-A- 2009 004 435
- JP-A- 2010 034 347
- US-A- 4 959 326
- US-A- 5 479 053
- US-A- 5 502 335
- US-A- 5 550 068
- US-A1- 2001 033 210
- US-A1- 2003 234 437
- US-A1- 2006 071 271
- US-B1- 6 400 027
- KOHNO Y ET AL: "K-Band High Gain and High Reliability Gaas Power Fet with Sub-Half Micron Wsi/au T-Shaped Gate", 19941016; 19941016 - 19941019, 16. Oktober 1994 (1994-10-16), Seiten 137-140, XP010255314,

## Beschreibung

### Stand der Technik

Gleichstrom durchsetzt einen elektrischen Leiter, durch den er geführt wird, komplett. Wechselstrom dringt nur bis zu einer material- und frequenzabhängigen Skintiefe in den Leiter ein, da das durch den Strom erzeugte magnetische Wechselfeld im Leiterinneren auf Grund der Lenzschen Regel eine Gegenspannung induziert, die den Strom an den Rand des Leiters drängt. Dadurch steht nur der Randbereich des Leiterquerschnitts bis zur Skintiefe für den Stromtransport zur Verfügung. Der Rest des Leiterquerschnitts trägt zum Stromtransport nichts bei. Um den elektrischen Widerstand des Leiters zu verringern, ist es bekannt, ihn zu vergrößern, so dass auch der den Strom tragende Randbereich größer wird. Nachteilig wird ein kleiner Zugewinn an Leitfähigkeit mit einem großen zusätzlichen Volumen an Leitermaterial erkauft, das wegen des Skin-Effekts nicht am Stromtransport teilnimmt. Die am besten leitenden Metalle sind Edelmetalle und daher sehr kostbar.

Die Vorrichtung gemäß dem Dokument US 2003/234437 A1 umfasst einen Hochfrequenzleiter mit mindestens einem elektrisch leitfähigen Basismaterial, bei dem das Verhältnis der von einem Strom durchsetzbaren äußeren und inneren Oberfläche des Basismaterials zum Gesamtvolumen des Basismaterials durch Aufteilung des Basismaterials senkrecht zur Stromrichtung in mindestens zwei Segmente, die durch ein elektrisch leitfähiges Zwischenstück beabstandet sowie elektrisch und mechanisch miteinander verbunden sind, gegenüber einer Formgebung des Basismaterials, bei der diese Aufteilung fortgelassen wurde, erhöht ist, wobei das Zwischenstück aus einem Material besteht, das von einem Ätzmittel, gegen das das Basismaterial beständig ist, angreifbar ist.

Nachteilig werden in dem Dokument keine Aussagen über die Ausdehnungen der Segmente und den damit verbundenen Materialaufwand einerseits und die Effizienz des Leiters andererseits getroffen.

### Aufgabe und Lösung

Es ist daher die Aufgabe der Erfindung, einen Hochfrequenzleiter zur Verfügung zu stellen, bei dem die Segmente eine Ausdehnung aufweisen, welche eine möglichst gute Leitfähigkeit bei gleichzeitig möglichst geringen Materialkosten bewirkt.

Diese Aufgabe wird erfindungsgemäß gelöst durch einen Hochfrequenzleiter gemäß Hauptanspruch sowie durch ein Herstellungsverfahren gemäß Nebenanspruch. Weitere vorteilhafte Ausgestaltungen ergeben sich aus den darauf rückbezogenen Unteransprüchen.

### Gegenstand der Erfindung

Im Rahmen der Erfindung wurde ein Hochfrequenzleiter entwickelt, der mindestens ein elektrisch leitfähiges Basismaterial umfasst.

Erfindungsgemäß umfasst die Vorrichtung mindestens ein elektrisch leitfähiges Basismaterial. Dieses ist senkrecht zur Stromrichtung in mindestens zwei Segmente aufgeteilt, die durch ein elektrisch leitfähiges Zwischenstück beabstandet sind. Das Zwischenstück besteht aus einem Material, das von einem Ätzmittel angreifbar ist, gegen das das Basismaterial beständig ist. Durch das Zwischenstück sind die Segmente elektrisch und mechanisch miteinander verbunden. Durch diese Formgebung ist das Verhältnis der von einem Strom durchsetzbaren äußeren und inneren Oberflächen des Basismaterials zum Gesamtvolumen des Basismaterials gegenüber einer Formgebung des Basismaterials, bei der diese Aufteilung fortgelassen wurde, erhöht.

Durch diese die Formgebung betreffenden Maßnahmen kann die gleiche Menge an Basismaterial räumlich so angeordnet werden, dass ein größerer Anteil des Basismaterials sich in einem Abstand von höchstens der Skintiefe von einer äußeren oder inneren Oberfläche befindet und somit am Stromtransport teilnimmt. Damit bleibt ein geringerer Anteil auf Grund des Skin-Effekts ungenutzt.

Erfindungsgemäß weist mindestens ein Segment des Basismaterials in jeder senkrecht auf der Stromrichtung stehenden Richtung eine Ausdehnung zwischen dem Doppelten der Skintiefe des Basismaterials bei der maximalen Betriebsfrequenz und dem 2,5-Fachen der Skintiefe des Basismaterials bei der niedrigsten Betriebsfrequenz auf. Eine geringere Ausdehnung schmälert die Leitfähigkeit, eine wesentlich höhere Ausdehnung bewirkt nur noch höhere Materialkosten, jedoch keinen weiteren Zuwachs an Leitfähigkeit.

Erfindungsgemäß besteht das Zwischenstück aus einem Material, das von einem Ätzmittel, gegen das das Basismaterial beständig ist, angegriffen werden kann. Dann kann der Hochfrequenzleiter besonders einfach hergestellt werden, indem alternierende Schichten aus dem Basismaterial und dem Material des Zwischenstücks auf das Substrat aufgewachsen werden und anschließend das Ätzmittel angewendet wird. Die Schichten aus dem Material des Zwischenstücks werden dann von zwei Seiten gleichzeitig angegriffen. In der Mitte zwischen beiden Angriffsstellen verbleibt ein Rest, dessen Breite von der Ätzdauer und der Ätzrate abhängt. Es ist keine komplizierte Abfolge von Lithographieschritten erforderlich.

Vom Zwischenstück ist lediglich zu fordern, dass es eine metallische Leitfähigkeit aufweist und dass es mechanisch stabil ist. Wenn der Hochfrequenzleiter auf einen Halbleiter aufgebracht wird, so gibt es zu jedem Halbleiter eine Gruppe besonders geeigneter leitfähiger Materialien, die z.B. einen Schottky-Kontakt mit dem Halbleiter bilden.

Vorteilhaft ist das Material des Zwischenstücks ein Metall aus der 3. oder 4. Hauptgruppe oder ein Übergangsmetall oder es enthält mindestens ein solches Metall als Legierungselement. Besonders vorteilhaft gehört das Material des Zwischenstücks zur Gruppe (Ti, V, Cr, Mn, Fe, Co, Ni, Cu, Zn) oder es enthält mindestens ein Metall aus dieser Gruppe als Legierungselement. Diese Materialien vereinen eine passable Leitfähigkeit mit einer guten Ätzbarkeit insbesondere durch nasschemische Ätzmittel. Wenn ein Herstellungsverfahren verwendet wird, bei dem es hierauf nicht ankommt, kann das Material des Zwischenstücks aber auch beispielsweise ein Edelmetall sein und insbesondere mit dem Basismaterial identisch sein.

Ist das Basismaterial topographisch strukturiert, weisen vorteilhaft mindestens 30 %, bevorzugt mindestens 50 % und ganz besonders bevorzugt mindestens 80 % der topographischen Strukturen in jeder senkrecht auf der Stromrichtung stehenden Richtung eine Ausdehnung zwischen dem Doppelten der Skintiefe des Basismaterials bei der maximalen Betriebsfrequenz und dem 2,5-Fachen der Skintiefe des Basismaterials bei der niedrigsten Betriebsfrequenz auf. Dann werden die Strukturen im Wesentlichen vollständig vom Strom durchsetzt.

Ist das Basismaterial porös, so beträgt vorteilhaft der kleinste Abstand von mindestens 30 %, bevorzugt mindestens 50 % und ganz besonders bevorzugt mindestens 80 % der Poren zu ihren nächsten Nachbarn zwischen dem Doppelten der Skintiefe des Basismaterials bei der maximalen Betriebsfrequenz und dem 2,5-Fachen der Skintiefe des Basismaterials bei der niedrigsten Betriebsfrequenz. Dann werden die Bereiche zwischen den Poren im Wesentlichen vollständig vom Strom durchsetzt, und es verbleiben nur geringe Mengen an Basismaterial, die nichts zum Stromtransport beitragen.

Vorteilhaft ist das Basismaterial Kohlenstoff oder ein Edel- oder Halbedelmetall oder es enthält mindestens ein Material aus dieser Gruppe als Legierungselement. In einer besonders vorteilhaften Ausgestaltung der Erfindung gehört das Basismaterial zur Gruppe (Ru, Rh, Pd, Ag, Os, Ir, Pt, Au) oder es enthält mindestens ein Metall aus dieser Gruppe als Legierungselement. Kohlenstoff und diese Edelmetalle sind nicht nur am besten elektrisch leitfähig, sondern auch beständig gegen Umwelteinflüsse sowie gegen nasschemische Ätzmittel, die eventuell zur Herstellung von Zwischenstücken verwendet werden.

In einer besonders vorteilhaften Ausgestaltung der Erfindung ist der Hochfrequenzleiter als Steuerelektrode eines Transistors ausgebildet. Er kann insbesondere als Gateelektrode eines Feldeffekttransistors ausgebildet sein. Bei einem Feldeffekttransistor kommt es im Interesse einer möglichst hohen Schaltfrequenz und Flankensteilheit des Umschaltens darauf an, die Gateelektrode möglichst schnell mit Ladung belegen oder umgekehrt Ladung möglichst schnell von ihr abführen zu können.

Vorteilhaft ist der Hochfrequenzleiter als Gateelektrode über ein elektrisch leitendes Zwischenstück, das die Gatelänge definiert, an eine halbleitende Feldeffekttransistorstruktur angekoppelt. Je kleiner die Gatelänge ist, desto größer ist die maximale Schaltfrequenz des Transistors.

In einer weiteren besonders vorteilhaften Ausgestaltung der Erfindung ist der Hochfrequenzleiter als Sammel- oder Ableitungselektrode eines Photodetektors ausgebildet. Insbesondere in einem Photodetektor nach dem MSM-Prinzip (metal - semi-conductor - metal) ist die Quantenausbeute um so besser, je geringer der elektrische Widerstand der Sammel- und Ableitungselektroden ist.

Nach dem zuvor Gesagten bezieht sich die Erfindung auch auf ein Verfahren zur Herstellung eines erfindungsgemäßen Hochfrequenzleiters. Dabei werden auf ein Substrat alternierende Schichten aus dem Material des Zwischenstücks und aus dem Basismaterial aufgewachsen. Der Schichtstapel wird anschließend einem Ätzmittel ausgesetzt, das das Material des Zwischenstücks isotrop ätzt und zugleich weder das Substrat noch das Basismaterial angreift. Durch das Zusammenspiel der Ätzrate mit der Ätzdauer kann die Breite des nach dem Ätzprozess verbleibenden Zwischenstücks eingestellt werden.

Vorteilhaft wird ein verdünnbares Ätzmittel gewählt. Die Ätzrate ist dann über den Verdünnungsgrad einstellbar. Das Ätzmittel kann beispielsweise eine Säure oder eine Base sein. Die Verdünnung kann, muss aber nicht mit Wasser erfolgen. Es können beispielsweise auch andere Lösungsmittel zur Verdünnung verwendet werden.

### Spezieller Beschreibungsteil

Nachfolgend wird der Gegenstand der Erfindung an Hand von Figuren erläutert, ohne dass der Gegenstand der Erfindung hierdurch beschränkt wird. Es ist gezeigt:
- Figur 1:: Ausführungsbeispiel des erfindungsgemäßen Hochfrequenzleiters.
- Figur 2:: Frequenzgang der erzielbaren Stromdichte und Vergleich mit dem Stand der Technik.
- Figur 3:: Ausführungsbeispiel des erfindungsgemäßen Herstellungsverfahrens.
- Figur 4:: Rasterelektronenmikroskopische Aufnahme des erfindungsgemäßen Hochfrequenzleiters und Vergleich mit dem Stand der Technik.
- Figur 5:: Frequenzgang der Kurzschlussstromverstärkung eines Transistors mit erfindungsgemäßem Hochfrequenzleiter als Gate und eines Transistors mit Gate gemäß Stand der Technik.

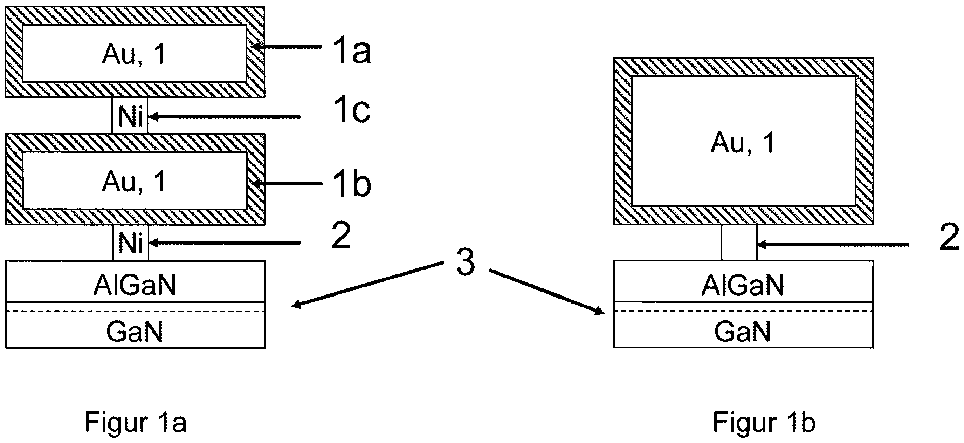

Figur 1a zeigt ein Ausführungsbeispiel des erfindungsgemäßen Hochfrequenzleiters 1 in Schnittzeichnung. Der Hochfrequenzleiter 1 ist über ein Zwischenstück 2 aus Nickel, das die Gatelänge definiert, an eine AlGaN/GaN-Heterostruktur 3 als halbleitende Feldeffekttransistorstruktur angekoppelt. Diese Heterostruktur befindet sich auf einem Saphirsubstrat. Das Substrat sowie das Source- und Draingebiet des Transistors einschließlich Kontaktierung sind aus Gründen der Übersichtlichkeit nicht eingezeichnet. Das Basismaterial Gold des Hochfrequenzleiters 1 ist in zwei Segmente 1 a und 1b aufgeteilt, die durch ein Zwischenstück 1c aus Nickel elektrisch und mechanisch miteinander verbunden sind. Der Strom, der dem Gate Ladung zuführt bzw. die Ladung wieder von ihm abführt, fließt senkrecht zur Zeichenebene. Auf Grund des Skin-Effekts tragen nur die oberflächennahen schraffierten Anteile der beiden Segmente 1 a und 1 b zum Stromtransport durch den Hochfrequenzleiter 1 bei. Der Stromtransport durch die schlechter leitenden Zwischenstücke 1c und 2 wird in Figur 1 aus Gründen der Übersichtlichkeit vernachlässigt.

Figur 1b zeigt zum Vergleich einen Hochfrequenzleiter 1 nach dem bisherigen Stand der Technik, der die gleiche Menge an Basismaterial enthält wie das Ausführungsbeispiel gemäß Figur 1a, in Schnittzeichnung. Hier ist die Aufteilung des Basismaterials in zwei Segmente fortgelassen. Infolgedessen entfallen die untere Kante des Segments 1 a und die obere Kante des Segments 1 b als oberflächennahe Bereiche, die zum Stromtransport beitragen. Damit wird nur ein deutlich geringerer Teil des kostbaren Basismaterials für den Stromtransport genutzt.

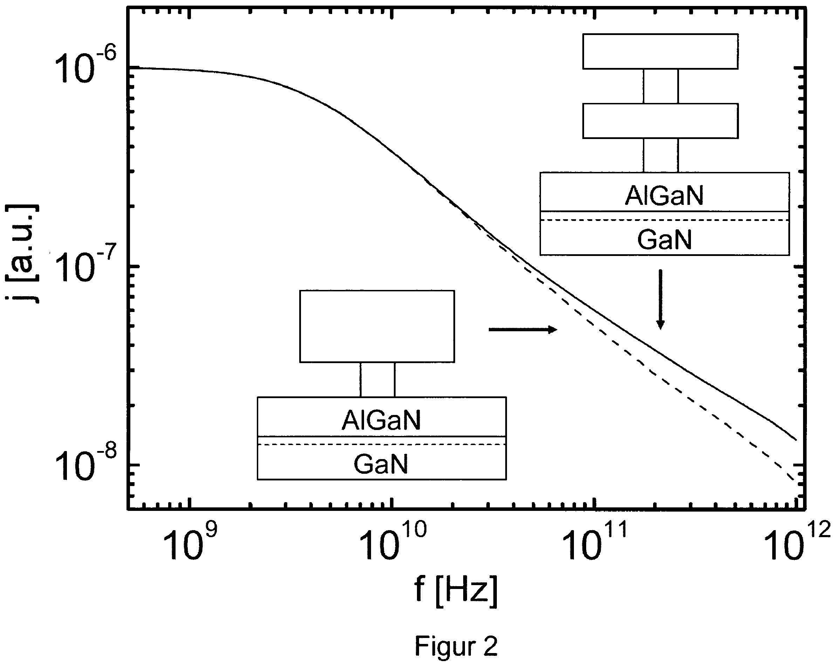

In Figur 2 ist für die Hochfrequenzleiter gemäß Figur 1a (durchgezogene Linie) und Figur 1b (gestrichelte Linie) der Frequenzgang der im Hochfrequenzleiter erzielbaren Stromdichte j über der Frequenz f doppelt logarithmisch aufgetragen. Für Frequenzen ab ca. 2*10¹⁰ Hz zeigt sich ein deutlicher Gewinn an Stromdichte bei gleichem Einsatz an Basismaterial.

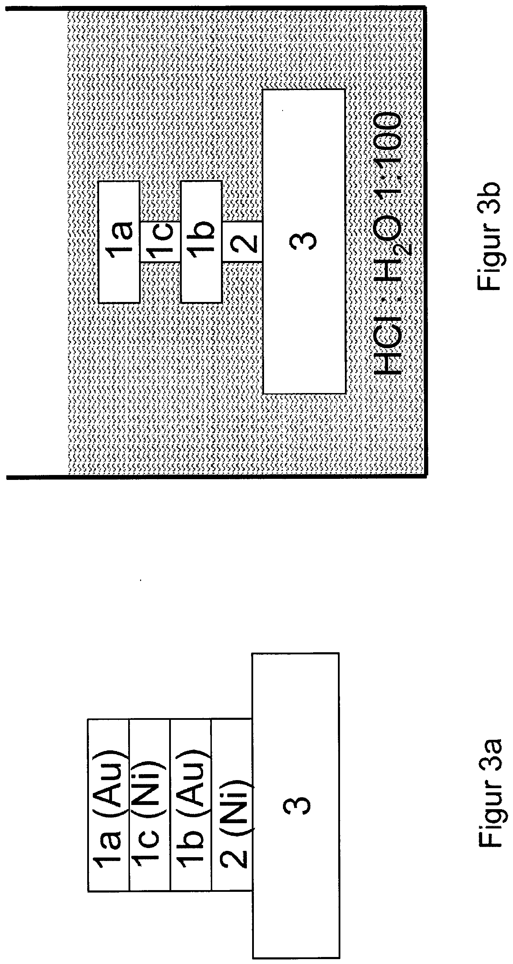

Figur 3 zeigt ein Ausführungsbeispiel des erfindungsgemäßen Herstellungsverfahrens, mit dem der in Figur 1 a gezeigte Hochfrequenzleiter hergestellt wurde. Auf eine kommerziell verfügbare, auf einem Saphir-Substrat aufgewachsene AlGaN/GaN Heterostruktur 3 wurden zunächst alternierende Schichten aus Nickel und Gold mit einer Dicke von jeweils 200 nm aufgewachsen (Figur 3a). Die Heterostruktur besteht aus einer 3 µm dicken undotierten GaN-Pufferschicht, auf der sich eine 30 nm dicke AlGaN-Barriere befindet. An der molaren Stoffmenge dieser Barriere hat AIN einen Anteil von 26 %. Nach dem Aufwachsen wurde der Schichtstapel einer mit Wasser verdünnten Salzsäure (HCl:H₂O 1:100) ausgesetzt, die die Nickelschichten jeweils von rechts und links angriff (Figur 3b). Nach dem Ätzen wurde der Schichtstapel für 10 min in deionisiertem Wasser gespült, um den weiteren Abbau der NickelSchichten zu stoppen. AFM-Messungen zeigten, dass durch das Ätzen die mittlere (rms) Rauhigkeit durch das Ätzen nicht erhöht worden war.

Unmittelbar auf der Heterostruktur 3 verblieb ein Nickel-Zwischenstück 2, das die Gatelänge des "high electron mobility transistors" (HEMT) definiert. Das zweite Nickel-Zwischenstück 1 c verbindet die beiden Segmente 1 a und 1 b des Basismaterials Gold.

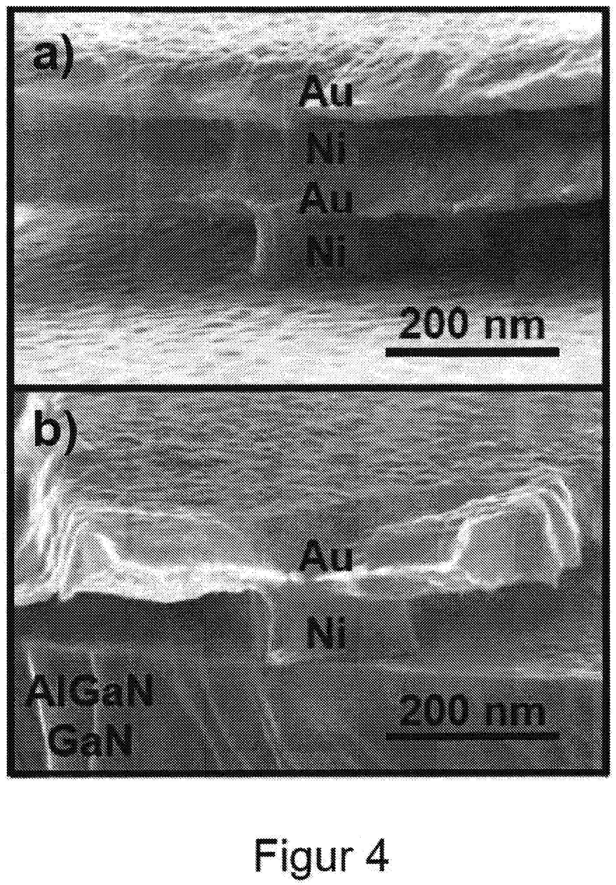

Figur 4a zeigt eine rasterelektronenmikroskopische Aufnahme des auf diese Weise hergestellten erfindungsgemäßen Hochfrequenzleiters, der dem Schema gemäß Figur 1a entspricht, im Querschnitt (Zwei-Level-T-gate). Figur 4b zeigt zum Vergleich eine rasterelektronenmikroskopische Aufnahme eines Beispiel für die herkömmliche T-gate Struktur (ein-Level T-Gate) nach dem Stand der Technik, das dem Schema gemäß Figur 1b entspricht, im Querschnitt.

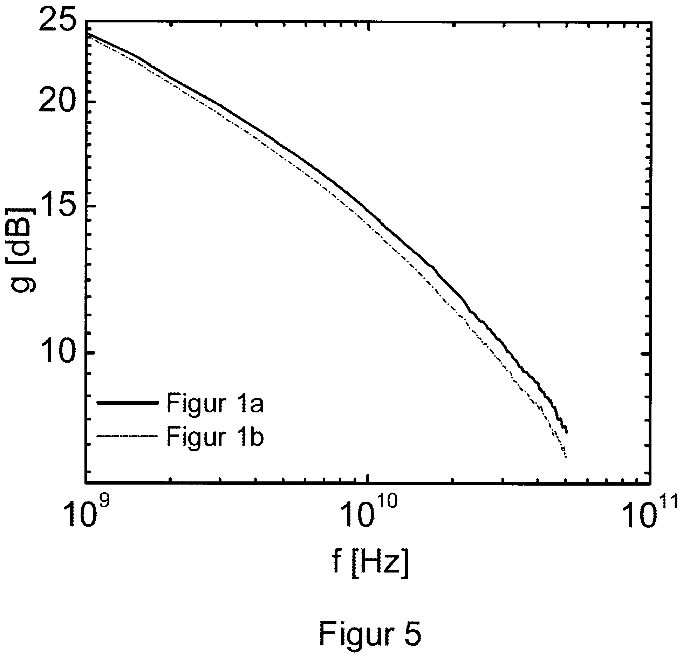

Figur 5 zeigt den Frequenzgang der Kurzschlussstromverstärkung g eines Transistors mit einem herkömmlichen T-Gate gemäß Stand der Technik (Figur 1b; dünne gepunktete Linie) und eines Transistors mit einem erfindungsgemäßen Zwei-Level-T-Gate (Figur 1 a; dicke durchgezogene Linie), aufgetragen jeweils über der Frequenz f. Beide Transistoren sind ansonsten identisch strukturiert. Der Vorteil des Transistors mit dem erfindungsgemäßen Hochfrequenzleiter als Gate wird bei hohen Frequenzen sichtbar. Damit verleiht der erfindungsgemäße Hochfrequenzleiter dem Transistor eine höhere Grenzfrequenz fₘₐₓ (höchste Frequenz, die ohne Dämpfung übertragen wird).

## Patentansprüche

1. Hochfrequenzleiter (1), umfassend mindestens ein elektrisch leitfähiges Basismaterial,
bei dem das Verhältnis der von einem Strom durchsetzbaren äußeren und inneren Oberflächen des Basismaterials zum Gesamtvolumen des Basismaterials durch Aufteilung des Basismaterials senkrecht zur Stromrichtung in mindestens zwei Segmente (1a),(1b), die durch ein elektrisch leitfähiges Zwischenstück (1c) beabstandet sowie elektrisch und mechanisch miteinander verbunden sind, welches aus einem Material besteht, das von einem Ätzmittel angreifbar ist, gegen das das Basismaterial beständig ist, gegenüber einer Formgebung des Basismaterials, bei der diese Aufteilung fortgelassen wurde, erhöht ist,
**dadurch gekennzeichnet, dass**
mindestens ein Segment in jeder senkrecht auf der Stromrichtung stehenden Richtung eine Ausdehnung zwischen dem Doppelten der Skintiefe des Basismaterials bei der maximalen Betriebsfrequenz und dem 2,5-fachen der Skintiefe des Basismaterials bei der niedrigsten Betriebsfrequenz aufweist.

2. Hochfrequenzleiter nach Anspruch 1, **dadurch gekennzeichnet, dass** das Material des Zwischenstücks ein Metall aus der 3. oder 4. Hauptgruppe oder ein Übergangsmetall ist oder dass es mindestens ein solches Metall als Legierungselement enthält.

3. Hochfrequenzleiter nach Anspruch 2, **dadurch gekennzeichnet, dass** das Material des Zwischenstücks zur Gruppe (Ti, V, Cr, Mn, Fe, Co, Ni, Cu, Zn) gehört oder mindestens ein Metall aus dieser Gruppe als Legierungselement enthält.

4. Hochfrequenzleiter nach einem der Ansprüche 1 bis 3, **dadurch gekennzeichnet, dass** das Basismaterial Kohlenstoff oder ein Edel- oder Halbedelmetall ist oder dass es mindestens ein Material aus dieser Gruppe als Legierungselement enthält.

5. Hochfrequenzleiter nach einem der Ansprüche 1 bis 4, **dadurch gekennzeichnet, dass** das Basismaterial zur Gruppe (Ru, Rh, Pd, Ag, Os, Ir, Pt, Au) gehört oder mindestens ein Metall aus dieser Gruppe als Legierungselement enthält.

6. Hochfrequenzleiter nach einem der Ansprüche 1 bis 5, **dadurch gekennzeichnet, dass** er als Steuerelektrode eines Transistors ausgebildet ist.

7. Hochfrequenzleiter nach Anspruch 6, **dadurch gekennzeichnet, dass** er als Gateelektrode eines Feldeffekttransistors ausgebildet ist.

8. Hochfrequenzleiter nach Anspruch 7, **dadurch gekennzeichnet, dass** er über ein elektrisch leitendes Zwischenstück, das die Gatelänge definiert, an eine halbleitende Feldeffekttransistorstruktur angekoppelt ist.

9. Hochfrequenzleiter nach einem der Ansprüche 1 bis 8, **dadurch gekennzeichnet, dass** er als Sammel- oder Ableitungselektrode eines Photodetektors ausgebildet ist.

10. Verfahren zur Herstellung eines Hochfrequenzleiters nach einem der Ansprüche 1 bis 9, **dadurch gekennzeichnet, dass** auf ein Substrat alternierende Schichten aus dem Material des Zwischenstücks und aus dem Basismaterial aufgewachsen werden und der Schichtstapel anschließend einem Ätzmittel ausgesetzt wird, das das Material des Zwischenstücks isotrop ätzt und zugleich weder das Substrat noch das Basismaterial angreift.

11. Verfahren nach Anspruch 10, **dadurch gekennzeichnet,**
**dass** ein verdünnbares Ätzmittel gewählt wird.

## Claims

1. High frequency conductor (1), comprising at least one electrically conductive base material,
in which the ratio of the outer and inner surfaces of the base material that may be crossed by a current to the total volume of the base material is increased by dividing the base material perpendicular to the direction of the current into at least two segments (1a), (1b), which are spaced as well as connected to each other electrically and
mechanically through an electrically conductive intermediate piece (1c), which is made of a material that may be attacked by an etching agent, against which the base material is resistant, with respect to shaping the base material, in which this division was omitted,
**characterised in that**
at least one segment in each direction running perpendicular to the direction of the current has an expansion between double the skin depth of the base material at the maximum operating frequency and 2.5 times the skin depth of the base material at the lowest operating frequency.

2. High frequency conductor according to claim 1, **characterised in that** the material of the intermediate piece is a metal from the 3rd of 4th main group or a transition metal or that it contains at least one such metal as an alloying element.

3. High frequency conductor according to claim 2, **characterised in that** the material of the intermediate piece belongs to the group (Ti, V, Cr, Mn, Fe, Co, Ni, Cu, Zn) or contains at least one metal from this group as an alloying element.

4. High frequency conductor according to one of claims 1 to 3, **characterised in that** the base material is carbon or a precious or semi-precious metal or that it contains at least one material from this group as an alloying element.

5. High frequency conductor according to one of claims 1 to 4, **characterised in that** the base material belongs to the group (Ru, Rh, Pd, Ag, Os, Ir, Pt, Au) or contains at least one metal from this group as an alloying element.

6. High frequency conductor according to one of claims 1 to 5, **characterised in that** it is made as a control electrode of a transistor.

7. High frequency conductor according to claim 6, **characterised in that** it is made as a gate electrode of a field effect transistor.

8. High frequency conductor according to claim 7, **characterised in that** it is connected to a semiconducting field effect transistor structure through an electrically conductive intermediate piece, which defines the gate length.

9. High frequency conductor according to one of claims 1 to 8, **characterised in that** it is made as a collecting or recording electrode of a photodetector.

10. Method for producing a high frequency conductor according to one of claims 1 to 9, **characterised in that** alternating layers made of the material of the intermediate piece and the base material are grown on a substrate and the stack of layers is then exposed to an etching agent, which etches the material of the intermediate piece isotropically and at the same time does not attack the substrate or the base material.

11. Method according to claim 10, **characterised in that** a dilutable etching agent is chosen.

## Revendications

1. Conducteur à haute fréquence (1), comprenant au moins un matériau de base électriquement conducteur,
dans lequel le rapport entre les surfaces externe et interne du matériau de base pouvant être parcourues par un courant et le volume total du matériau de base est augmenté par une division du matériau de base perpendiculairement au sens du courant en au moins deux segments (la), (1b) espacés par un espaceur électriquement conducteur (1c) et reliés l'un à l'autre de manière électrique et mécanique, lequel espaceur est constitué d'un matériau pouvant être attaqué par un agent de gravure auquel est résistant le matériau de base, par rapport à une mise en forme du matériau de base dans laquelle cette division a été supprimée,
**caractérisé en ce que**
au moins un segment, dans chaque direction perpendiculaire au sens du courant, présente une prolongation entre le double de l'épaisseur de film du matériau de base à la fréquence de fonctionnement maximale et 2,5 fois l'épaisseur de film du matériau de base à la fréquence de fonctionnement minimale.

2. Conducteur à haute fréquence selon la revendication 1, **caractérisé en ce que** le matériau de l'espaceur est un métal du 3ème ou du 4ème groupe principal ou un métal de transition ou **en ce qu'**il contient au moins un tel métal comme élément d'alliage.

3. Conducteur à haute fréquence selon la revendication 2, **caractérisé en ce que** le matériau de l'espaceur appartient au groupe (Ti, V, Cr, Mn, Fe, Co, Ni, Cu, Zn) ou contient au moins un métal parmi ce groupe comme élément d'alliage.

4. Conducteur à haute fréquence selon l'une quelconque des revendications 1 à 3, **caractérisé en ce que** le matériau de base est du carbone ou un métal précieux ou semi-précieux ou **en ce qu'**il contient au moins un matériau parmi ce groupe comme élément d'alliage.

5. Conducteur à haute fréquence selon l'une quelconque des revendications 1 à 4, **caractérisé en ce que** le matériau de base appartient au groupe (Ru, Rh, Pd, Ag, Os, Ir, Pt, Au) ou contient au moins un métal parmi ce groupe comme élément d'alliage.

6. Conducteur à haute fréquence selon l'une quelconque des revendications 1 à 5, **caractérisé en ce qu'**il est formé comme électrode de commande d'un transistor.

7. Conducteur à haute fréquence selon la revendication 6, **caractérisé en ce qu'**il est formé comme électrode de grille d'un transistor à effet de champ.

8. Conducteur à haute fréquence selon la revendication 7, **caractérisé en ce qu'**il est couplé à une structure de transistor à effet de champ semiconductrice via un espaceur électriquement conducteur qui définit la longueur de grille.

9. Conducteur à haute fréquence selon l'une quelconque des revendications 1 à 8, **caractérisé en ce qu'**il est formé comme électrode collectrice ou comme électrode de dérivation d'un photodétecteur.

10. Procédé de fabrication d'un conducteur à haute fréquence selon l'une quelconque des revendications 1 à 9, **caractérisé en ce que** des couches alternantes du matériau de l'espaceur et du matériau de base sont formées par croissance sur un substrat et l'empilement de couches est ensuite exposé à un agent de gravure qui grave le matériau de l'espaceur de manière isotrope et, en même temps, n'attaque ni le substrat ni le matériau de base.

11. Procédé selon la revendication 10, **caractérisé en ce qu'**est choisi un agent de gravure diluable.
